(19) Europäisches Patentamt / European Patent Office / Office européen des brevets

(11) **EP 3 602 083 B1**

(12) **EUROPEAN PATENT SPECIFICATION**

(45) Date of publication and mention
of the grant of the patent:
**26.01.2022 Bulletin 2022/04**

(21) Application number: **18716245.8**

(22) Date of filing: **05.04.2018**

(51) International Patent Classification (IPC):
*G01R 15/18* (2006.01)    *H02M 7/487* (2007.01)
*H02H 9/02* (2006.01)    *G01R 31/26* (2020.01)
*G01R 19/00* (2006.01)    *G01R 19/165* (2006.01)
*G01R 31/52* (2020.01)    *H02H 7/122* (2006.01)
*H02M 7/00* (2006.01)

(52) Cooperative Patent Classification (CPC):
**H02M 7/003; G01R 15/181; G01R 19/16552;
G01R 31/2644; G01R 31/52; H01L 23/62;
H02H 7/1227; H02M 1/0009**

(86) International application number:
**PCT/EP2018/058788**

(87) International publication number:
**WO 2018/189035 (18.10.2018 Gazette 2018/42)**

(54) **SHORT-CIRCUIT CURRENT SENSOR FOR POWER ELECTRONICS MODULE**

KURZSCHLUSSSTROMSENSOR FÜR LEISTUNGSELEKTRONIKMODUL

CAPTEUR DE COURANT DE COURT-CIRCUIT POUR MODULE ÉLECTRONIQUE DE PUISSANCE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **10.04.2017 EP 17165711**

(43) Date of publication of application:
**05.02.2020 Bulletin 2020/06**

(73) Proprietor: **ABB Schweiz AG
5400 Baden (CH)**

(72) Inventor: **TRAUB, Felix
5413 Birmenstorf (CH)**

(74) Representative: **Qip Patentanwälte
Dr. Kuehn & Partner mbB
Goethestraße 8
80336 München (DE)**

(56) References cited:
DE-A1-102015 009 092     JP-A- H11 317 495
US-A1- 2003 214 313     US-A1- 2012 223 697

**Description**

FIELD OF THE INVENTION

The invention relates to the field of power electronics modules. In particular, the invention relates to a power module and a method of detecting a short-circuit current through the power module.

BACKGROUND OF THE INVENTION

Power electronics converters usually are composed of a plurality of power electronics modules. In the case, one of the power electronics modules fails, there are often measures to continue a proper operation of the converter. For example, power electronics modules connected in series may be bypassed, when a failure occurs.

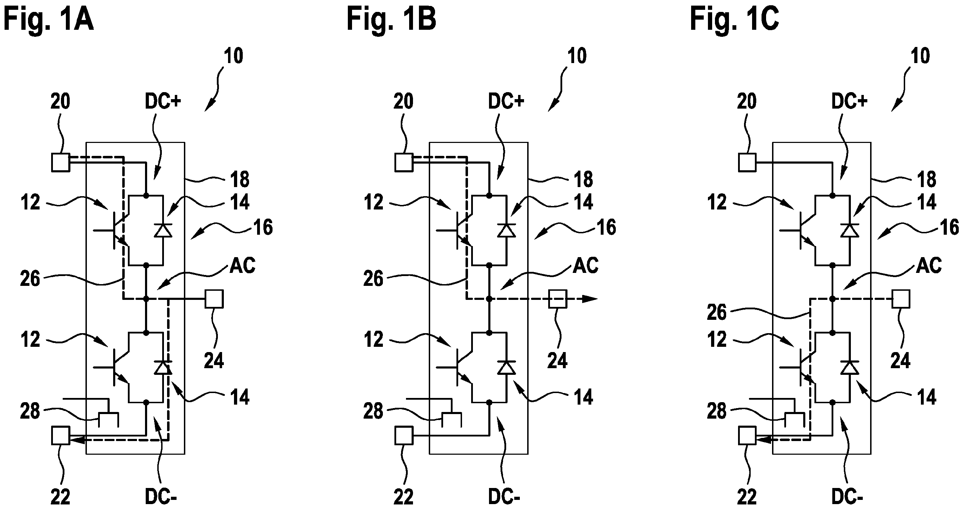

For determining, whether a power electronics module has a failure, a short-circuit current may be measured, which is usually much higher than the normally commuted current. In particular, as described with respect to Fig. 1 below, for a half-bridge module it is only necessary to measure the current through one of its DC terminals.

One possibility is to sense a voltage drop on the parasitic emitter inductance, which voltage drop is proportional to a change in the emitter current. Integration of the induced voltage over time then allows to estimate a total emitter current.

Furthermore, overcurrent events in an IGBT based converter may be detected by de-saturation detection, i.e., the collector-emitter voltage is measured to detect high voltages during on-state, indicating an excessive collector current leading to de-saturation of the IGBT. However, a de-saturation detection may need a complex implementation to measure a high-voltage signal, requiring large space due to isolation distances, and long detection times for type I short-circuit events due to blanking times after IGBT turn-on. Also, the measurement may not be used to estimate a collector current during normal operation.

A further possibility is to sense the current by a Rogowski coil wrapped around a DC terminal. While this is a promising concept, it is not directly applicable for industrial applications since a Rogowski coil and in particular a printed circuit board carrying the coil between the DC terminals may violate required clearance and creepage distances. Increasing the distance between the module terminals to account for clearance and creepage may increase a stray inductance.

For example, DE 102 44 266 A1 describes a method for determining a short-circuit current with a Rogowski coil.

US 2003/214 313 A1 shows a pick-up coil with two winding sections that may be placed at opposite sides of a conductor.

JP H11 317 495 A shows power semiconductor module housings and Rogowski coils, which circumvent all power terminals of the housings.

US 2012/223 697 A1 relates to a current sensor and shows a coil that only partially surrounds a conductor.

DE 10 2015 009 092 A1 relates to a current sensor and shows coils, which surround two conductors completely.

DESCRIPTION OF THE INVENTION

It is an objective of the invention to provide a simple and effective way to detect a short-circuit event in a power module.

This objective is achieved by the subject-matter of the independent claims. Further exemplary embodiments are evident from the dependent claims and the following description.

An aspect of the invention relates to a power module. A power module may be any assembly of semiconductor chips, their electrical interconnection and their mechanical support. For example, a power module may comprise a base plate carrying the semiconductor chips and optionally a housing encasing the semiconductor chips and the base plate. Furthermore, the power module may comprise terminals protruding from the housing, which are adapted for connecting the power module to further power electronic components, such as further power modules.

Here and in the following, the term "power" may relate to modules and/or semiconductor devices adapted for processing currents of more than 10 A and/or voltages of more than 100 V.

According to an embodiment of the invention, the power module comprises two semiconductor elements connected in series, i.e. into a series connection. Each semiconductor element may comprise a diode and/or, a semiconductor switch. The power module further comprises two DC terminals of different polarity, each DC terminal providing an electrical connection to an outer end of the series connection; an AC terminal providing an electrical connection to a midpoint of the series connection; and a pick-up coil arranged for sensing a time-varying magnetic field generated by a time-varying current flowing through the DC terminals and the AC terminal, the pick-up coil comprising a plurality of conductor loops wound around extension sections of the pick-up coil.

For example, the terminals may be metal pins protruding from the power module. The pick-up coil, which also may be called dI/dt measurement coil or sensing coil, is adapted for sensing a current change (dI/dt) (i.e. a time-varying current) in the terminals. Any current change through the terminals will generate a time-varying magnetic field, which induces a voltage in the pick-up coil. This voltage may be used for determining a change in current and therefore, by integration, the current.

The pick-up coil is made of conductor loops, which may be provided by wire or metal layers of a printed circuit board, which at least sectionally may be wound in a helix. An extension direction of such a helix or the center or center line of a curved helix may define an extension section of the pick-up coil. The extension sections may be connected in series for forming the pick-up coil.

The extension section of the pick-up coil may be arranged running besides one of the DC terminals, such that the pick-up coil surrounds the DC terminal only partially. Contrary to a Rogowski coil, the pick-up coil is not a closed ring, but has one or more extension sections that surround one of the DC terminals only partially. For example, all sections of the pick-up coil may only surround the DC terminal by 270° or less.

The pick-up coil and/or its extension sections may be arranged in a plane substantially orthogonal to a direction of the DC terminal.

The extension sections are positioned around one DC terminal. For example, the extension sections may form an interrupted ring around the DC terminal. The extension sections are positioned such that their extension direction and/or a center of a helix of conductor loops substantially follows a tangential direction around the DC terminal. The pick-up coil may be placed in proximity of one of the power module DC terminals and/or the turns or conductor loops may be oriented in a way to maximize the pick-up of magnetic stray fields from the power module DC terminals.

An opened pick-up coil has several advantages. Firstly, there is no need for a bigger space between the DC terminals, since the space between the DC terminals may be free of components of the pick-up coil and/or a mechanical structure, such as a printed circuit board, carrying the pick-up coil. The implementation of the pick-up coil may be simple with respect to clearance and creepage distances.

Secondly, contrary to a Rogowski coil, an opened pick-up coil may also sense magnetic fields generated by conductors, i.e. terminals that are positioned outside of the partial ring formed by the pick-up coil. In such a way, there also may be a coupling with the current through the outer DC terminal and/or the AC terminal. The positioning and form of the pick-up coil may be designed, such that corresponding coupling coefficients facilitate the detecting of a short-circuit current.

In particular, it may be possible to sense all current transients, i.e., both commutation/short-circuit current and output current in the power module with one pick-up coil. With the pick-up coil, a power module current during normal operation may be estimated and an overcurrent event due to an internal or external short-circuit may be detected. Additionally, expensive and bulky components such as current transducers can be omitted. Compared with circuit detection by de-saturation, the short-circuit detection with the pick-up coil is faster and does not require a high-voltage sensing circuit.

It has to be noted that it is possible, that the power module is equipped with solely one pick-up coil as described in the above and in the below. However, it is also possible that the power module is equipped with two or more such pick-up coils.

When the power module is used together with other power modules, which may be equally designed, in a converter with one or more phases, each power module may be equipped with one or more pick-up coils. Not all power modules may need to be provided with a pick-up coil as described in the above and in the below.

For example, the converter may comprise a phase, which comprises a single or several paralleled power modules. At least one of the power modules may be equipped with a pick-up coil as described in the above and in the following. It also may be that the converter comprises several phases, which are designed in such a way.

Furthermore, the pick-up coil has two extension sections running along opposite sides of the DC terminal, the two extension sections having conductor loops wound in the same direction with respect to a direction around the DC terminal. Each extension section may be formed of a substantially straight helix.

Additionally, the pick-up coil has an intermediate extension section connected between the two opposite extension sections. The intermediate extension section may be spaced apart from the opposite extension sections or may form a continuous coil together with the two extension sections. The intermediate extension section may be formed of a substantially straight helix.

The intermediate extension section may be used for adjusting the sensitivity of the pick-up coil with respect to differently oriented magnetic fields. For example, this may be done by an orientation of the winding of the intermediate section and/or a ratio between the number of loops of the opposite extension sections and the number of loops of the intermediate section.

It has to be noted that a direction around the DC terminal may be a direction in clockwise or counter clockwise direction with respect to an axis of the terminal. Furthermore, the conductor loops may be wound in a clockwise or a counter clockwise direction around a center line of the respective extension section. This center line may run around the DC terminal.

The two extension sections running along opposite sides of the DC terminal have conductor loops wound in the same direction with respect to a center line of the pick-up coil running around the DC terminal. With respect to this center line, both extension sections may be wound in a clockwise direction or counter clockwise direction.

The pick-up coil is arranged, such that the intermediate extension section is arranged between the DC terminal and the AC terminal. In such a way, the intermediate extension section may couple stronger to the electromagnetic field produced between the AC terminal and the DC terminal, while the two other extension sections may couple stronger to the electromagnetic field produced besides the DC terminal. The pick-up coil may differentiate between a current from one of the DC terminals to the AC terminal and between a current between the DC terminals.

According to an embodiment of the invention, the pick-up coil is arranged, such that no extension sections with conductor loops are arranged between the DC terminals of different polarity. In such a way, the creepage and clearance distance may be met without changing any distances between the terminals. In particular, the distance between the DC terminals need not be adapted to the presence of the pick-up coil.

According to an embodiment of the invention, the DC terminals are arranged besides each other and the AC terminal is arranged spaced apart from the DC terminals. For lowering a stray inductance, the DC terminals may be positioned to each other as close as possible. The AC terminal may be spaced apart from the DC terminals, i.e. a distance between the AC terminal and the DC terminals may be bigger than a distance between the DC terminals.

The DC terminals and the AC terminal may be arranged in a row along a longitudinal direction of a housing of the power module. The two opposite extension sections then may be aligned along the longitudinal direction and/or the intermediate extension section may be aligned transvers to the longitudinal direction. In this case, the two opposite extension sections may run substantially anti-parallel. The intermediate extension section may run substantially orthogonal to the opposite extension sections.

According to an embodiment of the invention, the pick-up coil is C-shaped, for example, having an opening angle of less than 270°.

In general, the pick-up coil may be designed that it forms an interrupted ring and/or a ring with an opening, which ring surrounds the DC terminal. The opening and/or the interruptions in the ring may be bigger than 90°.

According to an example not forming part of the claimed invention, the intermediate extension section has conductor loops wound in the same direction with respect to the direction around the DC terminal defined by the opposite extension sections. In this case, a voltage induced by a magnetic field in the intermediate extension section is added to a voltage induced in the opposite extension sections.

According to the invention, the intermediate extension section has conductor loops wound in an opposite direction with respect to the direction around the DC terminal defined by the opposite extension sections. In this case, a voltage induced by a magnetic field in the intermediate extension section is subtracted to a voltage induced in the opposite extension sections.

The intermediate extension section has conductor loops, which are wound in a specific direction with respect to a center line of the pick-up coil running around the DC terminal. With respect to this center line, the intermediate extension section is wound in a clockwise direction or counter clockwise direction.

According to an embodiment of the invention, a number of conductor loops of the intermediate extension section and a number of conductor loops of the opposite extension sections are selected, such that a coupling coefficient of the pick-up-coil with respect to a current between the AC terminal and one of the DC terminals is minimized. In particular, the ratio of number of loops of the extension section and the number of conductor loops of the opposite extension sections determine a weighting factor for the voltage induced in the intermediate extension section.

With the direction of the intermediate extension section and the number of loops, coupling coefficients of the pick-up coil to different current flow configurations may be selected in such a way that the pick-up coil is either most sensitive to one particular current change configuration or that it is able to reliably detect all current flow configurations in the same way. A current flow configuration may be defined by a time-varying current flowing between two different terminals, i.e. between a DC+ terminal and a DC- terminal or between a DC terminal and the AC terminal. For example, a maximum coupling coefficient may be assigned to a current flow configuration, where the change in current should be sensed with highest accuracy.

As an example, in order to detect a DC link short-circuit, it may be most important to maximize the coupling coefficient to the current flow path, which is taken by the short-circuit current. The coupling coefficient to other current flow configurations, such as a change in the output current of the AC terminal, may be minimized in order to avoid false detections.

In particular, the number of conductor loops, the position of the conductor loops, and the orientation of the conductor loops may be chosen in such a way that the coupling coefficients to the three basic current flow configurations in a power module (commutation between DC+ and DC-, current change between DC+ and AC, current change between AC and DC-) are each be tuned to a desired value. In particular, the orientation of the conductor loops of the pick-up coil may be different with respect to the magnetic field to be sensed, based on the position of the conductor loop.

In general, the desired values of the coupling coefficients and the design of the pick-up coil may be adjusted to the application, the topology of the converter, and/or the physical design of the current path, such as inside the power module and/or in the external bus bars.

According to an embodiment of the invention, the DC terminals are a DC+ terminal and a DC- terminal and the pick-up coil is arranged to surround partially the DC+ terminal or the DC- terminal.

According to an embodiment of the invention, the DC terminals and the AC terminal protrude from a terminal side of a housing of the power module, in which housing the two semiconductor elements are accommodated. All terminals may be pins protruding substantially orthogonal from the housing, which, for example, may be a plastics encasing. The pick-up coil may be aligned substantially parallel to the terminal side from which the terminals protrude.

Also, further terminals, such as gate terminals and/or sensor terminals, may be provided on the terminal side.

According to an embodiment of the invention, the DC terminal partially surrounded by the pick-up coil, the other DC terminal and/or the AC terminal is provided as a conductor pair and the pick-up coil partially surrounds the conductor pair. A conductor pair may be a pair of conductors or pins, electrically interconnected with each other. For example, a conductor pair may be provided by two substantially parallel pins protruding from the housing of the power module.

The opposite extension sections of the pick-up coil may be arranged, such that they are aligned in a line with the conductor pair. The intermediate section may run besides the conductor pair, i.e. substantially parallel the line defined by the conductor pair.

According to an embodiment of the invention, the pick-up coil comprises a return conductor running along the extension section in an opposite direction with respect to the conductor loops. The return conductor may be enclosed by the conductor loops and/or may be located besides the conductor loops, i.e. at least partially inside and/or at least partially outside of a helix defined by the conductor loops. The return conductor may be connected with one end of the pick-up coil and may run to another end of the pick-up coil.

According to an embodiment of the invention, the pick-up coil is provided on a printed circuit board. For example, the conductor loops and/or the return conductor of the pick-up coil may be provided by conductors printed on the printed circuit board.

According to an embodiment of the invention, the printed circuit board comprises a C-shaped section embracing the DC terminal. On this C-shaped section, the conductor loops of the pick-up coil may be arranged.

According to an embodiment of the invention, the printed circuit board provides a gate driver functionality for the two semiconductor chips. The pick-up coil may be integrated in an existing printed circuit board, such as a gate driver printed circuit board or a gate adapter printed circuit board. The gate driver may generate gate signals for the semiconductor chips. With a pick-up coil on the same printed circuit board as the gate driver, no additional printed circuit board is necessary.

According to an embodiment of the invention, the two semiconductor elements are forming a half-bridge. It may be that the semiconductor elements are two diodes, two semiconductor switches or one diode and one semiconductor switch connected in series. In the last case, the power module may be seen as a chopper module. Also, a free-wheeling diode may be connected antiparallel to a semiconductor switch. The two semiconductor elements may be connected in series, such they have the same (optionally controlled) conduction and/or forward direction.

A semiconductor switch may comprise a thyristor, a transistor, an IGBT, a reverse conducting IGBT, a reverse blocking IGBT, etc.

According to an embodiment of the invention, the two semiconductor elements are two semiconductor switches connected reversely with respect to each other. The two semiconductor elements may be connected, such that they have opposite controlled conduction and/or forward directions. Such a series connection also may be seen as an anti-series connection. For example, the two semiconductor elements may be connected, such they have a common emitter or a common collector. Such a power module may be employed in a so called neutral point piloted configuration. In this case, all the terminals of the power may in principle be connected to and/or may provide AC potentials. However, the terminals connected to outer ends of the series connection also will be called DC terminals and the terminal connected to the midpoint will be called AC terminal.

According to an embodiment of the invention, the printed circuit board provides an evaluation circuit for evaluating a voltage signal from the pick-up coil. The evaluation circuit may be interconnected with the pick-up coil, in particular with one end of the pick-up coil and with the return conductor. A voltage signal provided by the pick-up coil may be post-processed in a way to estimate a total current. Furthermore, the evaluation circuit may provide a signal for a controller, which indicates, whether a short-circuit event has occurred or not.

A further aspect of the invention relates to a method of detecting a short-circuit current through a power module as described in the above and in the following. It has to be understood that features of the method as described in the above and in the following may be features of the system as described in the above and in the following. For example, the method may be performed by an evaluation circuit that, for example, may be provided on a circuit board that also carries the pick-up coil.

According to an embodiment of the invention, the method comprises: measuring a voltage induced in the pick-up coil; integrating the measured voltage over time; detecting a short-circuit current, when the integrated signal is higher than a threshold. A current through the DC terminals and the AC terminals induces a voltage in the pick-up coil, which is proportional to the derivative of the current and the coupling constant with respect to the respective current path. Thus, by integrating the measured voltage, for example, with a passive integrator circuit, a signal indicative of the current is generated. Due to the arrangement and design of the pick-up coil, a short-circuit current will induce higher voltages than the commutated current. A short-circuit current may then be detected, when the integrated signal becomes higher than a threshold value. The threshold value may be determined in the design phase of the power module.

These and other aspects of the invention will be apparent from and elucidated with reference to the embodiments described hereinafter.

BRIEF DESCRIPTION OF THE DRAWINGS

The subject-matter of the invention will be explained in more detail in the following text with reference to exemplary embodiments which are illustrated in the attached drawings.

Fig. 1A, 1B and 1C schematically show a circuit diagram with current flows of a power module according to an embodiment of the invention.
Fig. 2 schematically shows a circuit diagram of three interconnected power modules according to an embodiment of the invention.
Fig. 3 shows a schematic perspective view of a power module according to an embodiment of the invention.
Fig. 4 shows a schematic perspective view of a pick-up coil for a power module according to an example not forming part of the claimed invention.
Fig. 5 shows a schematic top view of the power module of Fig. 3.
Fig. 6 shows a further schematic top view of the power module of Fig. 3.
Fig. 7 shows a schematic perspective view of a power module which is not forming part of the claimed invention.
Fig. 8 shows a schematic top view of the power module according to a further embodiment of the invention.
Fig. 9 shows a diagram with coupling coefficients for a pick-up coil for a power module according to an embodiment of the invention.
Fig. 10 shows a diagram with measured and integrated voltages over time sensed by a pick-up coil for a power module according to an embodiment of the invention.

The reference symbols used in the drawings, and their meanings, are listed in summary form in the list of reference symbols. In principle, identical parts are provided with the same reference symbols in the figures.

DETAILED DESCRIPTION OF EXEMPLARY EMBODIMENTS

Fig. 1A, 1B and 1C show a power module 10 with two semiconductor elements 12 in the form of semiconductor switches connected in series. Every semiconductor element 12 (for example with an IGBT as semiconductor switch) may comprise a free-wheeling diode 14 connected in parallel to the semiconductor switch.

It may be that the upper and/or the lower semiconductor element 12, 14 comprises solely a diode. The semiconductor elements 12, 14 then may form a half-bridge 16. It also may be that the upper and/or the lower semiconductor element 12, 14 are connected with opposite controlled conduction directions as described above, i.e. may be connected in anti-series. In the following the case with two semiconductor elements 12, 14 connected in series with the same controlled conduction direction will be described. However, it has to be understood that also other configurations in combination with the features described below are possible for the power module 10.

The semiconductor elements 12, 14 may be enclosed by a housing 18, which provides three terminals 20, 22, 24. A DC+ terminal 20 is connected to an upper end DC+ of the half-bridge 16. A DC- terminal 22 is connected to a lower end DC- of the half-bridge 16. An AC terminal 24 is connected to a midpoint AC of the half-bridge 16.

A semiconductor elements 12 may be provided with gate signals, such that different currents may be generated in the power module 10. For example, the power module 10 may be part of an inverter and/or may be connected in parallel with a DC link via its DC terminals 20, 22.

A current I, 26 between the different terminals 20, 22, 24 and in particular a changing current is sensed with a pick-up coil 28. Changing currents 26 through the power module 10 generate changing magnetic fields, which induce a voltage in the pick-up coil 28 that may be used for determining the magnitude of the current.

Fig. 1A, 1B and 1C show three basic configurations of current changes dI/dt. In Fig. 1, the current commutates from the DC+ terminal 20 to the DC- terminal 22 or vice versa, i.e. there is a positive current change dI/dt in one DC terminal and an opposite current change dI/dt on the other terminal. The sum of the current change dI/dt in the DC terminals 20, 22 is zero. While such a configuration cannot be maintained statically during normal operation, it correctly describes a time-varying component of the current during commutation. This configuration also appears during DC link short-circuit events. Very high current change dI/dt values can appear both during normal operation (such as 10k A/us during commutation events) as well as during short-circuit events.

In the configuration of Fig. 1B, a positive current change dI/dt on the DC+ terminal 20 is accompanied by an opposite current change dI/dt in the AC terminal 24 and a zero dI/dt on the DC- terminal 22. Note that the net current change dI/dt in the DC terminals 20, 22 is nonzero in this case. During normal operation, the corresponding current change dI/dt (~10A/us) is much smaller than for the first configuration in Fig. 1A. High current changes dI/dt can appear, however, during an overcurrent event due to an external short-circuit (such as AC to ground).

In Fig. 1C, a third configuration is shown, which has a positive current change dI/dt in the AC terminal 24, accompanied by an opposite current change dI/dt in the DC- terminal 22. The same comments as for the configuration of Fig. 1B apply.

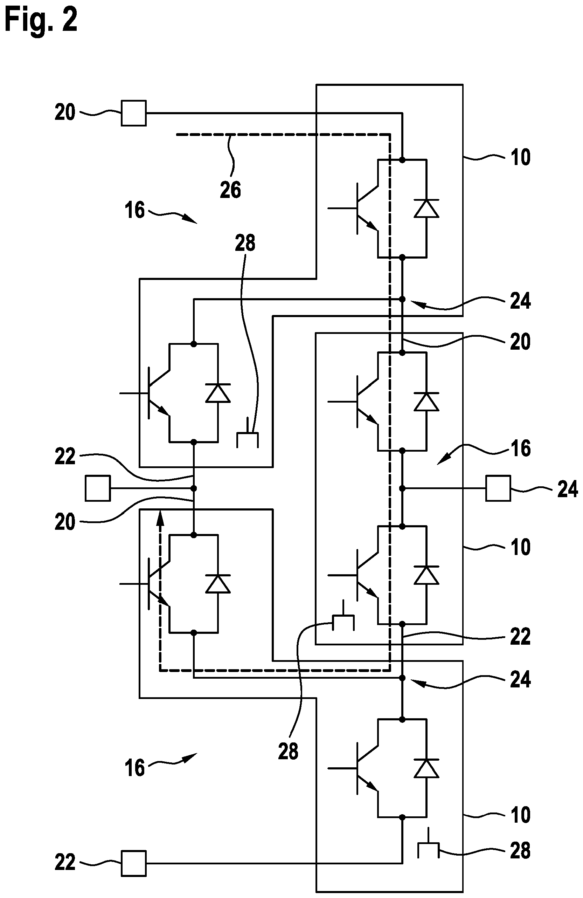

Fig. 2 shows a phase of a 3-Level (A)NPC converter, which is composed of three modules as shown in Fig. 1A to 1C. As shown in Fig. 2, every power module may comprise a pick-up coil 28. In Fig. 2, a short-circuit current 26 is shown, which may appear during commutation or DC-link short-circuit events. In this case, a similar configuration as in Fig. 1B arises for the upper power module 10. Since at the same time, the middle power module 10 is in the configuration of Fig. 1A, it may be that only a short-circuit event has to be detected in the configuration of Fig. 1A.

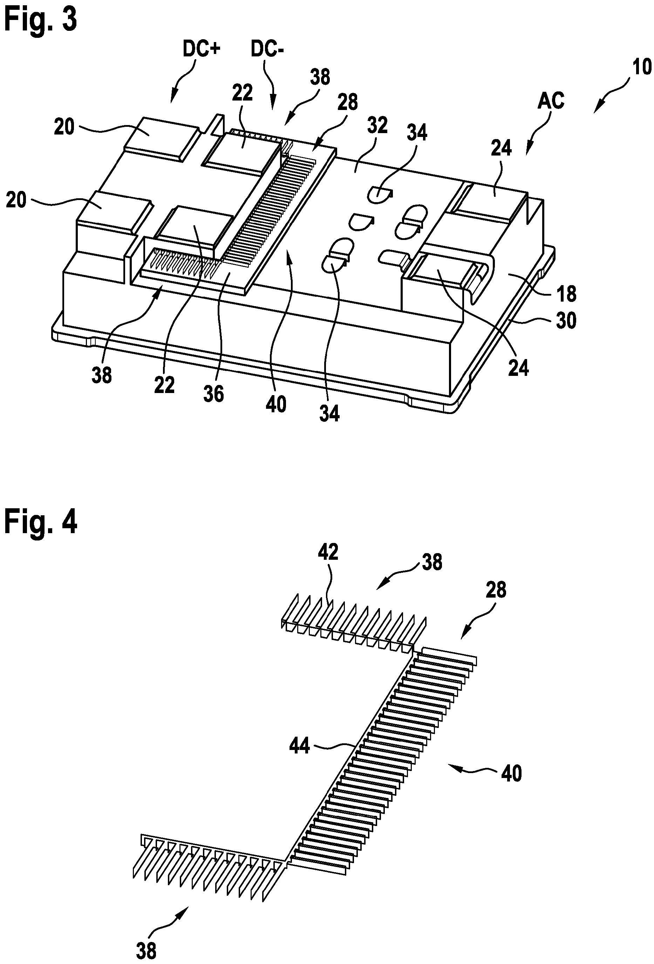

Fig. 3 shows an upper power module 10 comprising a base plate 30, a housing 18 on the base plate 30, which housing accommodates the semiconductor elements 12, 14 and their electrical interconnection as shown in Fig. 1A. All terminals 20, 22, 24 of the upper power module 10 are provided on an upper side 32 of the upper power module 10, which may be seen as a terminal side 32.

The DC+ terminal 20 and the DC- terminal 22 are arranged near each other to lower a stray inductance between them. The AC terminal 24 is spaced apart from the DC terminals 20, 22. The terminals 20, 22, 24 are provided as conductor pairs, i.e. every terminal 20, 22, 24 is provided by two conductors which are arranged besides each other.

On the terminal side 32, further terminals 34 are provided, which, for example, may be gate terminals or sensor terminals.

The DC- terminal 22 is partially surrounded by a C-shaped printed circuit board 36, which may be attached to the terminal side 32 of the housing 18. The printed circuit board 36 carries the pick-up coil 28, which also partially surrounds the DC- terminal 22. Here and in the following, the DC+ terminal 20 and the DC- terminal 22 may be exchanged.

As shown in Fig. 3, the pick-up coil extends around the DC- terminal 22 from a first side of the DC- terminal 22 to an opposite side of the DC- terminal 22, i.e. may surround the DC- terminal more than 180°. On the other hand, the pick-up coil 28 is not present on the side of the DC- terminal 22 facing the DC+ terminal 20. In such a way, the creepage and clearance distances between the DC terminals 20, 22 do not have to be adapted to the pick-up coil 28.

In Fig. 3, the pick-up coil 28 is divided into two opposite extension sections 38 and one intermediate extension section 40. It has to be noted that the sections 38, 40 also may be seen as one extension section, when they are not spaced apart from each other. The opposite extension sections 38 are straight helical coils extending parallel to each other. Also the intermediate extension section 40 is a straight helical coil, which extends orthogonal to the opposite extension sections 38.

The pick-up coil 28 and the extension sections 38, 40 are shown in detail in Fig. 4. The pick-up coil 28 and the extension sections 38, 40 are made of conductor loops 42, which are interconnected to helical coils. A return conductor 44 is running in parallel to the extension sections 38, 40 near to the conductor loops 42. The pick-up coil 28 and the return conductor 44 may be provided as layers and vias of the printed circuit board 36.

In an example not forming part of the claimed invention and as shown in Fig. 4, the extension sections 38, 40 may be wound in the same direction. According to the invention the intermediate section is wound in an opposite direction with respect to the opposite extension sections 38.

When the pick-up coil 28 is placed into a time-varying magnetic field, the k-th conductor loop 42 experiences an induced voltage based on the law of magnetic induction

$$V_k = -\frac{\mathrm{d}\Phi_\mathrm{k}}{\mathrm{d}t} = -\int_{A_k} \frac{d\vec{B}}{dt}\,d\vec{n} \approx a\,\frac{d\vec{B}(x_k)\cdot\vec{n}_k}{dt}$$

where $\Phi_k = \int_{A_k}\vec{B}\,\vec{n}$ is the magnetic flux in the conductor loop 42, $A_k$ is the surface area of the conductor loop, $\vec{n}_k$ the normal vector to the surface, and $\vec{B}(x_k)$ the magnetic field at the position of the k-th conductor loop. Summing all conductor loops, the induced voltage of the pick-up coil 28 is

$$V = \sum_k A \frac{d\vec{B}}{dt}(x_k) \cdot \vec{n_k} \approx \frac{A \cdot N}{l} \cdot \frac{d}{dt} \int_\gamma \vec{B} \cdot d\vec{s}$$

In other words, the induced voltage in the pick-up coil 28 is approximately proportional to the line integral of the magnetic field along the path y formed by the pick-up coil 28. If the time-varying magnetic field is produced by a time-varying current, the equation can be reformulated:

$$V \approx \frac{A \cdot N}{l} \cdot \frac{d}{dt} \int_\gamma \vec{B} \cdot d\vec{s} = M \frac{dI}{dt} \propto \frac{dI}{dt}$$

If the path y of the pick-up coil 28 forms a closed loop around the current carrying conductor, the pick-up coil 28 may be seen as a Rogowski coil. In this case, the dependence on the time-varying current can be computed explicitly:

$$V \approx \frac{A \cdot N}{l} \frac{d}{dt} \oint \vec{B} \cdot d\vec{s} = \frac{A \cdot N}{l} \frac{d}{dt} \int_S (\nabla \times \vec{B}) \cdot \vec{n} = \frac{a \cdot N \cdot \mu_0}{l} \frac{d}{dt} \int_S \vec{j} \cdot d\vec{n} = \frac{a \cdot N \cdot \mu_0}{l} \frac{dI}{dt}$$

where S is the surface enclosed by the coil and *I* is the net current flowing through this surface.

However, in the present case, the pick-up coil 28 forms an open loop or open ring. As shown above, the pick-up coil 28 effectively performs a line integration of the magnetic field along its path or, in other words, along its extension.

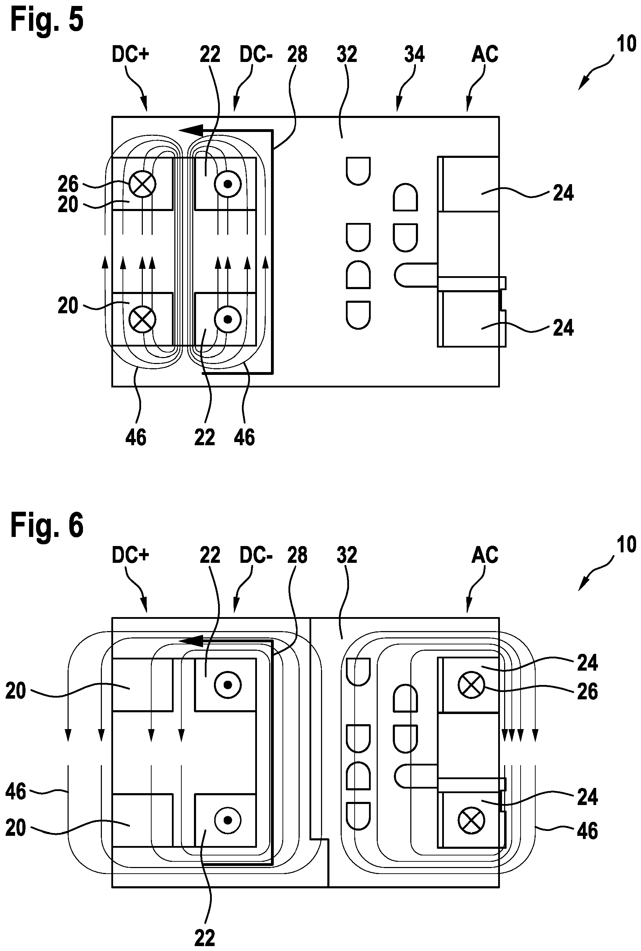

Fig. 5 and 6 show the power module 10 from above. The pick-up coil 28 is only shown schematically as its corresponding integration path for the magnetic field.

In Fig. 5, a transient magnetic field 46 during a short-circuit event is shown. The current 26 corresponds to the configuration shown in Fig. 1A. It can be expected, that the transient magnetic field 46 produces a considerable induced voltage in the pick-up coil, if it is integrated along the extension of the pick-up coil 28.

Fig. 6 shows the transient magnetic field 46, when a changing current 26 flows from the AC terminal 4 to the DC- terminal 22. This corresponds to the configuration of Fig. 1C. The pick-up coil 28 also couples strongly to this current 26, since the magnetic field 46 is also integrated by the pick-up coil along its extension.

For specific power modules 10, the pick-up coil 28 shown in Fig. 3 and 4 may result in a coupling coefficient for the configuration in Fig. 6, which is higher than for the short-circuit current configuration shown in Fig. 5. This may be related to a higher stray inductance of the current flow path, producing a stronger magnetic field which is then integrated. In this case, a short-circuit current may be falsely detected based on a high current between the AC terminal 24 and the DC- terminal.

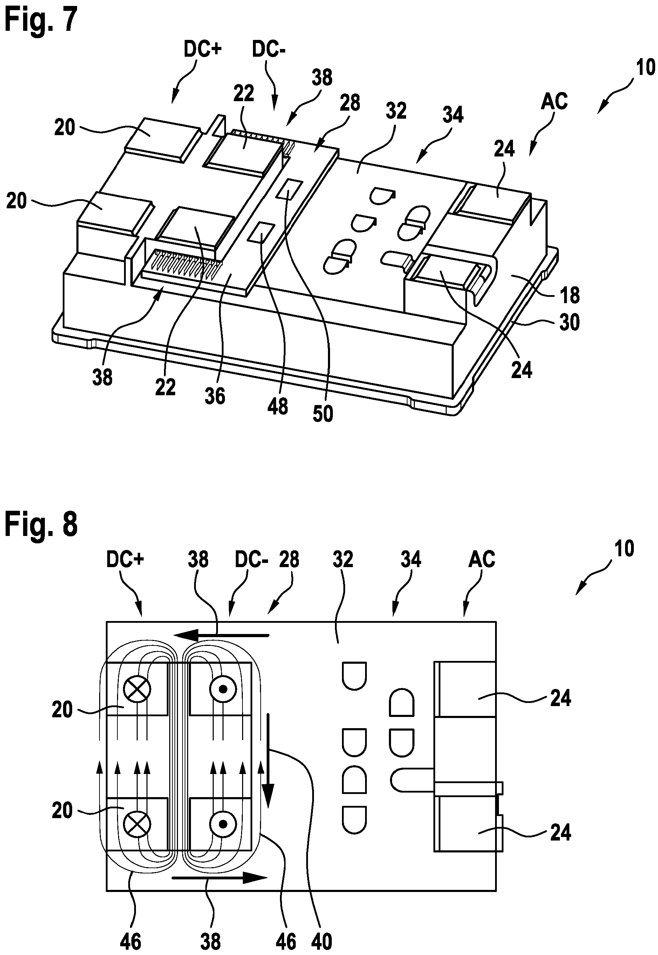

In Fig. 7 and 8, power modules 10, which have reduced coupling coefficients with respect to the configurations shown in Fig. 1B and 1C, are presented.

In an example not forming part of the claimed invention and as shown in Fig. 7, a reduction of these coupling coefficients may be achieved by omitting the intermediate extension section 40. The pick-up coil 28 of Fig. 7 only comprises two opposite extension sections 38 on opposite sides of the DC- terminal 22, which are more remote from the AC terminal 24 than the side of the DC- terminal 22 facing the AC terminal 24.

Furthermore, Fig. 7 shows that the printed circuit board 36 may carry a gate driver circuit 48 and/or an evaluation circuit 50 for evaluating the voltage signal from the pick-up coil 28.

Fig. 8 shows the pick-up coil 28 only in the form of its integration path along its extension. In Fig. 8, the intermediate extension section 40 of the pick-up coil is wound in the opposite direction.

Coupling coefficients of the pick-up coil 28 to output current configurations with a current through the AC terminal 24 may be further reduced by noting that while the magnetic field 46 in both configurations follows quantitatively the same path, the field strength along the path is not constant. More specifically, the magnetic field strength due to short-circuit currents decreases much faster with distance from the DC terminals 20, 22 than the field strength due to output currents.

In consequence, the coupling coefficient to output current changes dI/dt may be reduced by adding conductor loops 42 with opposite orientation at sufficient distance from the DC terminals 20, 22.

In Fig. 8, at two sides of the DC- terminal 22, two extension sections 38 of the pick-up coil 28 are designed to integrate the transient magnetic field 46 during short-circuit events. In the center, the intermediate extension section 40 with a number of N conductor loops 42 is coupled with opposite direction to the magnetic field 46.

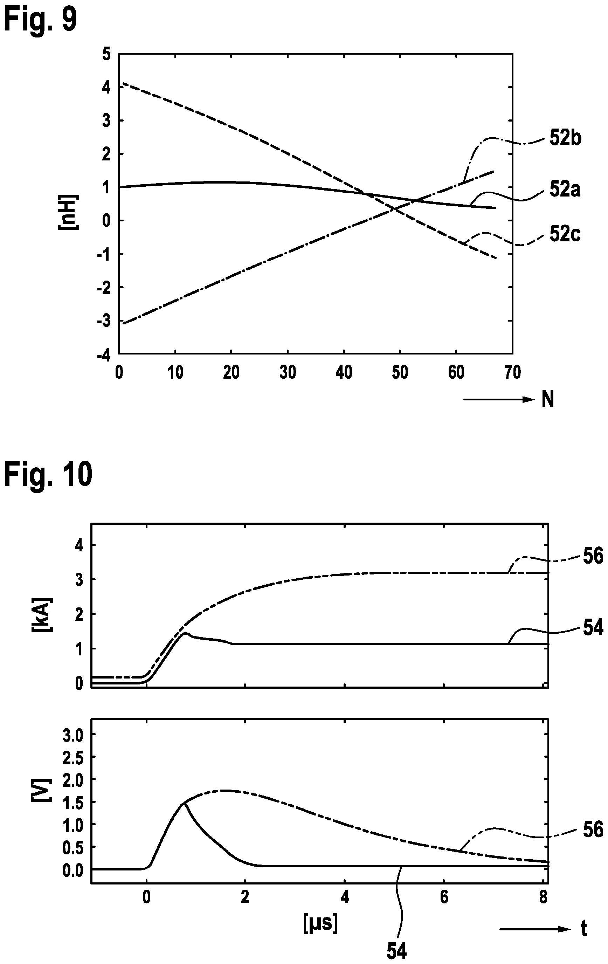

Fig. 9 shows a diagram with the resulting coupling coefficients 52a, 52b, 52c for the three basic configurations of Fig. 1A, 1B and 1C as function of the number N of negatively oriented conductor loops 42 for the pick-up coil 28 of Fig. 8. By changing the number N of negatively oriented conductor loops 42, the coupling coefficients 52b, 52c to the output current configurations can be adjusted even such that they are lower than the coupling coefficient 52a of the configuration of Fig. 1A.

In general, the desired values for the coupling coefficients 52a, 52b, 52c may depend strongly on the topology.

For 2-level converters, the current change dI/dt of the output current is usually so low that even a high coupling coefficient does not produce false short-circuit detections. Therefore, a design with a number N of not negatively oriented conductor loops 42 in the intermediate extension section 40, such as shown in Fig. 3 to 6, or a design with no conductor loops 42 in the intermediate extension section 40, such as shown in Fig. 7, may be chosen.

For 3-level converters, such as shown in Fig. 2, a high current change dI/dt through the AC terminal 24 also may appear frequently during normal commutations. In this case, a design as shown in Fig. 8 may be chosen in order to avoid false short-circuit signals during those transitions.

Fig. 10 shows examples for a normal commutation event 54 and a short-circuit event 56. In the upper diagram, the current over time t through the DC- terminal 22 is shown for both events 54, 56. The lower diagram shows the voltage induced in the pick-up coil 28 and integrated by a passive integrator for estimating the current. The short-circuit event 56 produces a significantly stronger signal, indicative of the higher current in this case. Thus, a short-circuit event 56 may be discriminated from a normal commutation event 54 by choosing an enough high threshold value and comparing the integrated voltage signal from the pick-up coil 28 with this threshold value.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art and practising the claimed invention, from a study of the drawings, the disclosure, and the appended claims. In the claims, the word "comprising" does not exclude other elements or steps, and the indefinite article "a" or "an" does not exclude a plurality. A single processor or controller or other unit may fulfil the functions of several items recited in the claims. The mere fact that certain measures are recited in mutually different dependent claims does not indicate that a combination of these measures cannot be used to advantage. Any reference signs in the claims should not be construed as limiting the scope.

LIST OF REFERENCE SYMBOLS

| 10 | power module |
| 12 | semiconductor element |
| 14 | free-wheeling diode |
| 16 | half-bridge |
| 18 | housing |
| 20 | DC+ terminal |
| 22 | DC- terminal |
| 24 | AC terminal |
| 26 | current |
| 28 | pick-up coil |
| 30 | base plate |
| 32 | terminal side |
| 34 | further terminal |
| 36 | printed circuit board |
| 38 | extension section |
| 40 | extension section |
| 42 | conductor loop |
| 44 | return conductor |
| 46 | magnetic field |
| 48 | gate driver circuit |
| 50 | evaluation circuit |
| 52a | coupling coefficient |
| 52b | coupling coefficient |
| 52c | coupling coefficient |
| 54 | commutation event |
| 56 | short-circuit event |

**Claims**

1.  A power module (10), comprising:

    two semiconductor elements (12) connected in series;
    two DC terminals (20, 22) of different polarity, each DC terminal (20, 22) providing an electrical connection to an outer end of the series connection of the two semiconductor elements (12);
    an AC terminal (24) providing an electrical connection to a midpoint of the series connection;
    a pick-up coil (28) arranged for sensing a time-varying magnetic field (46) generated by a time-varying current (26) flowing through the DC terminals (20, 22) and the AC terminal (24), the pick-up coil (28) comprising a plurality of conductor loops (42) wound in two extension sections (38) and an intermediate extension section (40) of the pick-up coil (28) such that the pick-up coil (28) surrounds one of the DC terminals (22) only partially;
    wherein the two extension sections (38) run along opposite sides of the one of the DC terminals (22), the two extension sections (38) having conductor loops (42) wound in the same clockwise direction or counter clockwise direction with respect to a center line of the pick-up coil (28) running around the one of the DC terminals (22);
    wherein the intermediate extension section (40) is connected between the two opposite extension sections (38), the power module being **characterized in that**
    the intermediate section is arranged between the one of the DC terminals (22) and the AC terminal (24); and **in that** the intermediate extension section (40) has conductor loops (42) wound in the opposite clockwise direction or counter clockwise direction with respect to the center line of the pick-up coil (28).

2.  The power module (10) of claim 1,
    wherein the pick-up coil (28) is arranged, such that no extension sections with conductor loops are arranged between the DC terminals (20, 22) of different polarity.

3.  The power module (10) of one of the previous claims,
    wherein a number of conductor loops (42) of the intermediate extension section (40) and a number of conductor loops of the opposite extension sections (38) are selected, such that a coupling coefficient (52b, 52c) of the pick-up-coil (28) with respect to a current between the AC terminal (24) and one of the DC terminals (20, 22) is minimized.

4.  The power module (10) of one of the previous claims,

    wherein the DC terminals of different polarity are a DC+ terminal (20) and a DC-terminal (22);
    wherein the pick-up coil (28) is arranged to surround partially the DC+ terminal or the DC- terminal.

5.  The power module (10) of one of the previous claims,
    wherein the DC terminals (20, 22) and the AC terminal (24) are provided on a terminal side (32) of a housing (18) of the power module (10), in which housing (18) the two semiconductor elements (12) are accommodated.

6.  The power module (10) of one of the previous claims,
    wherein the DC terminal (22) is provided as a conductor pair and the pick-up coil (28) partially surrounds the conductor pair.

7.  The power module (10) of one of the previous claims,

    wherein the pick-up coil (28) is provided on a printed circuit board (36);
    wherein conductor loops (42) of the pick-up coil (28) are provided by conductors of the printed circuit board (36);
    wherein the printed circuit board (36) comprises a C-shaped section embracing the DC terminal (22).

8.  The power module (10) of one of the previous claims,

    wherein the two semiconductor elements (12) form a half-bridge (16); or
    wherein the two semiconductor elements (12) are two semiconductor switches connected reversely with respect to each other.

9.  A method of detecting a short-circuit current through a power module (10) according to one of the previous claims, the method comprising:

measuring a voltage induced in the pick-up coil (28);
integrating the measured voltage over time;
detecting a short-circuit current, when the integrated signal is higher than a threshold.

**Patentansprüche**

1. Leistungsmodul (10), das Folgendes umfasst:

    zwei Halbleiterelemente (12), die in Reihe geschaltet sind;
    zwei Gleichstromanschlüsse (20, 22) mit verschiedener Polarität, wobei jeder Gleichstromanschluss (20, 22) eine elektrische Verbindung mit einem äußeren Ende der Reihenschaltung der zwei Halbleiterelemente (12) bereitstellt;
    einen Wechselstromanschluss (24), der eine elektrische Verbindung mit einem Mittelpunkt der Reihenschaltung bereitstellt;
    eine Aufnahmespule (28), die zum Erfassen eines zeitlich veränderlichen Magnetfelds (46), das durch einen zeitlich veränderlichen Strom (26) erzeugt wird, der durch die Gleichstromanschlüsse (20, 22) und den Wechselstromanschluss (24) fließt, ausgelegt ist, wobei die Aufnahmespule (28) mehrere Leiterschleifen (42) umfasst, die in zwei Verlängerungsabschnitten (38) und einem Zwischenverlängerungsabschnitt (40) der Aufnahmespule (28) gewickelt sind, derart, dass die Aufnahmespule (28) einen (22) der Gleichstromanschlüsse lediglich teilweise umgibt;
    wobei die zwei Verlängerungsabschnitte (38) entlang gegenüberliegender Seiten des einen (22) der Gleichstromanschlüsse verlaufen, wobei die zwei Verlängerungsabschnitte (38) Leiterschleifen (42) aufweisen, die in derselben Richtung im Uhrzeigersinn oder Richtung gegen den Uhrzeigersinn in Bezug auf eine Mittenlinie der Aufnahmespule (28), die um den einen (22) der Gleichstromanschlüsse verläuft, gewickelt sind;
    wobei der Zwischenverlängerungsabschnitt (40) zwischen den zwei gegenüberliegenden Verlängerungsabschnitten (38) angeschlossen ist,
    wobei das Leistungsmodul **dadurch gekennzeichnet ist, dass**
    der Zwischenabschnitt zwischen dem einen (22) der Gleichstromanschlüsse und dem Wechselstromanschluss (24) angeordnet ist;
    und dass der Zwischenverlängerungsabschnitt (40) Leiterschleifen (42) aufweist, die in der entgegengesetzten Richtung im Uhrzeigersinn oder Richtung gegen den Uhrzeigersinn in Bezug auf die Mittenlinie der Aufnahmespule (28) gewickelt sind.

2. Leistungsmodul (10) nach Anspruch 1,
    wobei die Aufnahmespule (28) derart angeordnet ist, dass zwischen den Gleichstromanschlüssen (20, 22) mit verschiedener Polarität keine Verlängerungsabschnitte mit Leiterschleifen angeordnet sind.

3. Leistungsmodul (10) nach einem der vorhergehenden Ansprüche,
    wobei eine Anzahl Leiterschleifen (42) des Zwischenverlängerungsabschnitts (40) und eine Anzahl Leiterschleifen der gegenüberliegenden Verlängerungsabschnitte (38) derart ausgewählt sind, dass ein Kopplungskoeffizient (52b, 52c) der Aufnahmespule (28) in Bezug auf einen Strom zwischen dem Wechselstromanschluss (24) und dem einen der Gleichstromanschlüsse (20, 22) minimiert ist.

4. Leistungsmodul (10) nach einem der vorhergehenden Ansprüche,

    wobei die Gleichstromanschlüsse mit verschiedener Polarität ein positiver Gleichstromanschluss (20) und ein negativer Gleichstromanschluss (22) sind;
    wobei die Aufnahmespule (28) derart angeordnet ist, dass sie den positiven Gleichstromanschluss oder den negativen Gleichstromanschluss teilweise umgibt.

5. Leistungsmodul (10) nach einem der vorhergehenden Ansprüche,
    wobei die Gleichstromanschlüsse (20, 22) und der Wechselstromanschluss (24) auf einer Anschlussseite (32) eines Gehäuses (18) des Leistungsmoduls (10) vorgesehen sind, wobei in dem Gehäuse (18) die zwei Halbleiterelemente (12) aufgenommen sind.

6. Leistungsmodul (10) nach einem der vorhergehenden Ansprüche,
    wobei der Gleichstromanschluss (22) als ein Leiterpaar vorgesehen ist und die Aufnahmespule (28) das Leiterpaar teilweise umgibt.

**7.** Leistungsmodul (10) nach einem der vorhergehenden Ansprüche,

wobei die Aufnahmespule (28) auf einer gedruckten Leiterplatte (36) vorgesehen ist;
wobei Leiterschleifen (42) der Aufnahmespule (28) durch Leiter der gedruckten Leiterplatte (36) bereitgestellt werden;
wobei die gedruckte Leiterplatte (36) einen C-förmigen Abschnitt, der den Gleichstromanschluss (22) umgibt, umfasst.

**8.** Leistungsmodul (10) nach einem der vorhergehenden Ansprüche,

wobei die zwei Halbleiterelemente (12) eine Halbbrücke (16) bilden; oder
wobei die zwei Halbleiterelemente (12) zwei Halbleiterschalter sind, die in Bezug aufeinander umgekehrt angeschlossen sind.

**9.** Verfahren zum Detektieren eines Kurzschlussstroms durch ein Leistungsmodul (10) nach einem der vorhergehenden Ansprüche, wobei das Verfahren Folgendes umfasst:

Messen einer Spannung, die in der Aufnahmespule (28) induziert wird;
Integrieren der gemessenen Spannung über die Zeit;
Detektieren eines Kurzschlussstroms, wenn das integrierte Signal höher als ein Schwellenwert ist.

**Revendications**

**1.** Module de puissance (10), comprenant :

deux éléments semi-conducteurs (12) connectés en série ;
deux bornes à courant continu (20, 22) de polarité différente, chaque borne à courant continu (20, 22) procurant une connexion électrique avec une extrémité extérieure de la connexion en série des deux éléments semi-conducteurs (12) ;
une borne à courant alternatif (24) procurant une connexion électrique avec un point milieu de la connexion en série ;
une bobine détectrice (28) agencée pour détecter un champ magnétique variable dans le temps (46) généré par un courant variable dans le temps (26) circulant dans les bornes à courant continu (20, 22) et la borne à courant alternatif (24), la bobine détectrice (28) comprenant une pluralité de boucles de conducteur (42) enroulées dans deux segments en extension (38) et un segment en extension intermédiaire (40) de la bobine détectrice (28) de sorte que la bobine détectrice (28) n'entoure que partiellement l'une des bornes à courant continu (22) ;
les deux segments en extension (38) s'étendant le long de côtés opposés de ladite une des bornes à courant continu (22), les deux segments en extension (38) présentant des boucles de conducteur (42) enroulées dans le même sens horaire ou sens antihoraire par rapport à une ligne centrale de la bobine détectrice (28) s'étendant autour de ladite une des bornes à courant continu (22) ;
le segment en extension intermédiaire (40) étant connecté entre les deux segments en extension opposés (38), le module de puissance étant **caractérisé en ce que** le segment intermédiaire est agencé entre ladite une des bornes à courant continu (22) et la borne à courant alternatif (24) ;
et **en ce que** le segment en extension intermédiaire (40) présente des boucles de conducteur (42) enroulées dans le sens horaire ou sens antihoraire opposé par rapport à la ligne centrale de la bobine détectrice (28).

**2.** Module de puissance (10) selon la revendication 1,
dans lequel la bobine détectrice (28) est agencée de sorte qu'aucun segment en extension pourvu de boucles de conducteur ne soit agencé entre les bornes à courant continu (20, 22) de polarité différente.

**3.** Module de puissance (10) selon l'une des revendications précédentes,
dans lequel un nombre de boucles de conducteur (42) du segment en extension intermédiaire (40) et un nombre de boucles de conducteur des segments en extension opposés (38) sont choisis de sorte à minimiser un coefficient de couplage (52a, 52b) de la bobine détectrice (28) par rapport à un courant entre la borne à courant alternatif (24) et l'une des bornes à courant continu (20, 22).

4. Module de puissance (10) selon l'une des revendications précédentes,

dans lequel les bornes à courant continu de polarité différente sont une borne à courant continu positive (20) et une borne à courant continu négative (22) ;
dans lequel la bobine détectrice (28) est agencée de manière à entourer partiellement la borne à courant continu positive ou la borne à courant continu négative.

5. Module de puissance (10) selon l'une des revendications précédentes,
dans lequel les bornes à courant continu (20, 22) et la borne à courant alternatif (24) sont placées d'un côté bornes (32) d'un boîtier (18) du module de puissance (10), le boîtier (18) accueillant les deux éléments semi-conducteurs (12).

6. Module de puissance (10) selon l'une des revendications précédentes,
dans lequel la borne à courant continu (22) prend la forme d'une paire de conducteurs et la bobine détectrice (28) entoure partiellement la paire de conducteurs.

7. Module de puissance (10) selon l'une des revendications précédentes,

dans lequel la bobine détectrice (28) est placée sur une carte de circuit imprimé (36) ;
dans lequel des boucles de conducteur (42) de la bobine détectrice (28) sont fournies par des conducteurs de la carte de circuit imprimé (36) ;
dans lequel la carte de circuit imprimé (36) comprend un segment en C englobant la borne à courant continu (22).

8. Module de puissance (10) selon l'une des revendications précédentes,

dans lequel les deux éléments semi-conducteurs (12) forment un demi-pont (16) ; ou
dans lequel les deux éléments semi-conducteurs (12) sont deux interrupteurs semi-conducteurs connectés en inverse l'un par rapport à l'autre.

9. Procédé de détection d'un courant de court-circuit traversant un module de puissance (10) selon l'une des revendications précédentes, le procédé comprenant :

la mesure d'une tension induite dans la bobine détectrice (28) ;
l'intégration de la tension mesurée par rapport au temps ;
la détection d'un courant de court-circuit lorsque le signal intégré est supérieur à un seuil.

Fig. 1A

Fig. 1B

Fig. 1C

# Fig. 2

## Fig. 3

## Fig. 4

## Fig. 5

## Fig. 6

**Fig. 7**

DC+ DC- 38
22 28 32 34 AC 10
20 24
20 18
30
24
38 22 36 48 50

**Fig. 8**

DC+ 38 DC- 28 32 34 AC 10
20 24
20 24
46 38 46 40

## Fig. 9

## Fig. 10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 10244266 A1
- US 2003214313 A1
- JP H11317495 A
- US 2012223697 A1
- DE 102015009092 A1